(19) Europäisches Patentamt
European Patent Office
Office européen des brevets

(11) **EP 4 303 659 A1**

(12) **EUROPEAN PATENT APPLICATION**

(43) Date of publication:
**10.01.2024 Bulletin 2024/02**

(21) Application number: **22183960.8**

(22) Date of filing: **08.07.2022**

(51) International Patent Classification (IPC):
***G03F 7/20*** (2006.01)

(52) Cooperative Patent Classification (CPC):
**G03F 7/70825; G03F 7/7085**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **BUTLER, Hans**
 **5500 AH Veldhoven (NL)**
• **MUTSAERS, Marinus, Engelbertus, Cornelis**
 **5500 AH Veldhoven (NL)**
• **DE JONGH, Robertus, Johannes, Marinus**
 **5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD OF DETERMINING A PARASITIC FORCE OF AN ACTUATOR OF AN OPTICAL COMPONENT, CONTROL METHOD FOR AN ACTUATOR, OPTICAL SYSTEM, PROJECTION SYSTEM AND LITHOGRAPHIC APPARATUS**

(57)    A method of determining a parasitic force of an actuator of an optical component is described, whereby the actuator is mounted to a first frame and is configured to control a position of the optical component relative to a second frame. The method comprises:
- obtaining a first position signal representing a position of the optical component relative to the first frame;
- performing a low-pass filtering to the first position signal;
- obtaining a second position signal representing a position of the optical component relative to the second frame;
- performing a high-pass filtering to the second position signal, the high-pass filtering being complementary to the low-pass filtering;
- determining the parasitic force of the actuator, based on the combined low-pass filtered first position signal and the high-pass filtered second position signal.

Fig. 3

**Description**

FIELD

The present invention relates to control methods for actuators that are used in the positioning of optical components such as mirrors in an EUV lithographic apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The lithographic apparatus may e.g. be configured to generate a patterned radiation beam and project said beam onto the substrate, so as to cause the substrate to be patterned. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The manufacturing of an integrated circuit may typically require that multiple layers with specific patterns are generated in sequence and stacked onto each other. In order to ensure proper operation of the integrated circuit, the specific patterns need to be accurately aligned. In order to achieve this, it is important to ensure that the radiation beam comprising the pattern, as projected by the lithographic apparatus, is projected at the desired location on the substrate. In order to achieve this accurate positioning of the pattern, it is important to ensure an accurate control of all optical components that are arranged in the optical path of the radiation beam comprising the pattern.

In particular the position of the optical components that are arranged in the optical path between the patterning device and the substrate need to be accurately controlled. It has been observed that known solutions to control the positioning of these optical components may not be accurate enough, in particular when the optical components need to be displaced along a trajectory during the projection of the radiation beam.

SUMMARY

It is an object of the present invention to enable a more accurate positioning of optical components in a lithographic apparatus, in particular optical components arranged in an optical path between the patterning device and the substrate.

According to an aspect of the invention, there is provided a method of determining a parasitic force of an actuator of an optical component, the actuator being mounted to a first frame and being configured to control a position of the optical component relative to a second frame, the method comprising:

- obtaining a first position signal representing a position of the optical component relative to the first frame;
- performing a low-pass filtering to the first position signal;
- obtaining a second position signal representing a position of the optical component relative to the second frame;
- performing a high-pass filtering to the second position signal, the high-pass filtering being complementary to the low-pass filtering;
- determining the parasitic force of the actuator, based on the combined low-pass filtered first position signal and the high-pass filtered second position signal.

According to another aspect of the invention there is provided another method of determining a parasitic force of an actuator of an optical component, the actuator being mounted to a frame and configured to control a position of the optical component relative to the frame, the method comprising:

- obtaining a position signal representing a position of the optical component relative to the frame;
- performing a low-pass filtering to the position signal;
- obtaining a reference signal representing a desired position of the optical component relative to the frame;
- performing a high-pass filtering to the reference signal, the high-pass filtering being complementary to the low-pass filtering;
- determining a parasitic force of the actuator, based on the combined low-pass filtered position signal and the high-pass filtered reference signal.

According to yet another aspect of the invention, there is provided a method of controlling an actuator, the actuator being mounted to a first frame and being configured to control a position of an optical component relative to a second frame, the method comprising:

- obtaining a reference signal representing a desired position of the optical component relative to the second frame and an optical component position signal representing a measured position of the optical component relative to the second frame;
- determining a parasitic force of the actuator using the method according to the invention,
- determining, based on the reference signal, the optical component position signal and the determined parasitic force, a control signal for controlling the actuator.

According to yet another aspect of the invention, there is provided an optical system comprising:

- an optical component such as a mirror;
- an actuator mounted to a first frame of the apparatus, the actuator being configured to control a position of the optical component relative to a second frame of the apparatus;
- a control unit, the control unit being configured to:

  ◦ obtaining a reference signal representing a desired position of the optical component relative to the second frame and an optical component position signal representing a measured position of the optical component relative to the second frame;
  ◦ determining a parasitic force of the actuator by:

  ▪ obtaining a first position signal representing a position of the optical component relative to the first frame;
  ▪ performing a low-pass filtering to the first position signal to obtain a low-pass filtered signal;
  ▪ performing a high-pass filtering to the optical component position signal or the reference signal to obtain a high-pass filtered signal, the high-pass filtering being complementary to the low-pass filtering;
  ▪ determining the parasitic force of the actuator, based on the combined low-pass filtered signal and the high-pass filtered signal;

  ◦ determining, based on the reference signal, the optical component position signal and the determined parasitic force, a control signal for controlling the actuator.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2 depicts a control scheme for and actuator configured to control a position or positioning of an optical component;
- Figure 3 schematically shows an optical system as can be applied in a projection system of a lithographic apparatus according to the invention;
- Figure 4 schematically shows Bode plots of complementary high-pass and low-pass filters;
- Figure 5 schematically shows a characteristic force profile of an actuator as can be applied in the present invention;
- Figure 6 schematically shows a flowchart of the method of determining a parasitic force of an actuator according to the invention;
- Figure 7 schematically shows a flowchart of a control method for an actuator according to the invention;
- Figures 8-10 schematically show control schemes as can be applied in accordance with the present invention;
- Figure 11 schematically shows another optical system as can be applied in a projection system of a lithographic apparatus according to the invention.

DETAILED DESCRIPTION

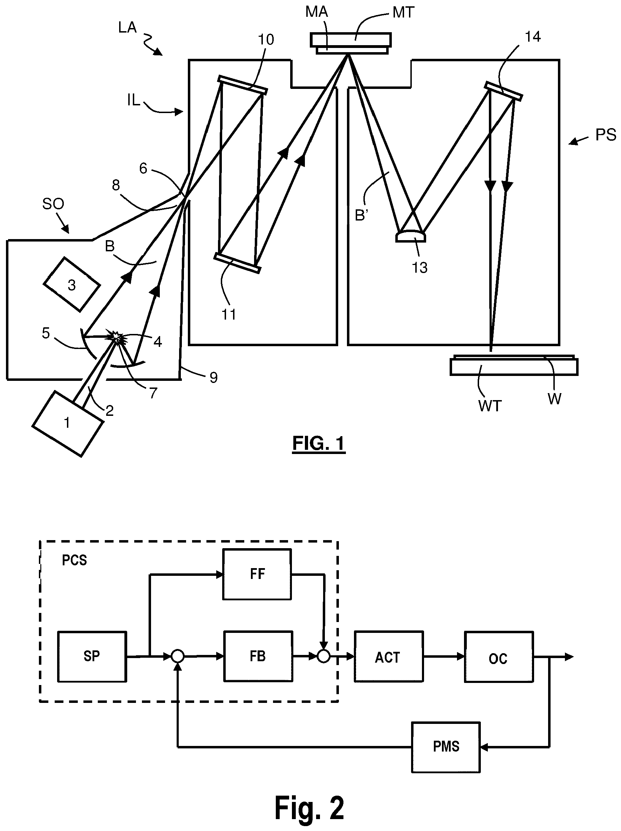

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The lithographic apparatus LA comprises a position control system PCS as schematically depicted in Figure 2. Such a position control system can e.g. be used to control an actuator as applied in the lithographic apparatus LA, e.g. an actuator used to control a position of an optical component as applied in the lithographic apparatus, e.g. a mirror 13, 14 of the projection system PS as shown in Figure 1. The position control system PCS as shown comprises a setpoint generator SP, a feedforward controller FF and a feedback controller FB. The position control system PCS provides a drive signal to the actuator ACT. In the control scheme, the actuator ACT drives the optical component OC, which may comprise a mirror or the like. The driving of the optical component AC by the actuator ACT may cause a displacement of the optical component OC. In the control scheme as shown, the displacement or position of the optical component OC is measured with the position measurement system PMS. The position measurement system PMS generates a signal, which is a position signal representative of the position quantity of the optical component OC. The setpoint generator SP generates a signal, which is a reference signal representative of a desired position quantity of the optical component OC. For example, the reference signal represents a desired trajectory of the optical component OC. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the optical component OC, such as mass, stiffness, resonance modes and eigenfrequencies.

In order to ensure accurate projection of a pattern of a patterning device onto a substrate, the projection system that is arranged in the optical path between the patterning device and the substrate may typically comprise multiple mirrors, e.g. 4 or more mirrors. An accurate position of said mirrors is needed to ensure that a radiation beam which is patterned with the pattern of the patterning device is projected at the desired location on the substrate. In order to facilitate such accurate positioning, it has been proposed to control a positioning of such mirrors by using a first frame for the mounting of the actuators that exert forces on the mirror in order to obtain the desired position or positioning, and using a second frame as a reference frame for the position or positioning of the mirrors.

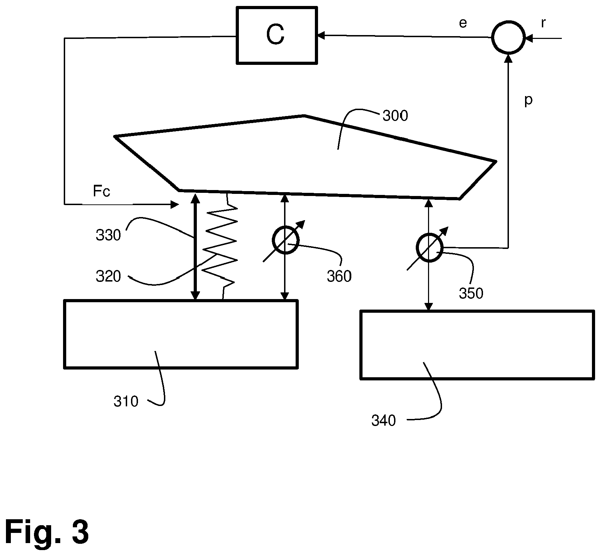

Such an arrangement is schematically shown in Figure 3. Figure 3 schematically shows a mirror 300, in general an optical component, as can e.g. be applied in a projection system of a lithographic apparatus such as apparatus LA shown in Figure 1. Figure 3 schematically shows a first frame 310 that is configured to support or hold an actuator 320 that is configured to exert a force, indicated by the arrow 330, onto the mirror 300. Figure 3 further shows a second frame 340 and a position measurement system 350 configured to measure a position of the mirror 300 relative to the second frame 340. Note that the second frame may, within the meaning of the present invention, be referred to as a reference frame or sensor frame. The first frame 310, onto which the actuator 320 is mounted, may, within the meaning of the present invention, be referred to as a force frame. Figure 3 further schematically shows how a position control of the mirror 300 can be realized. In Figure 3, a controller or control unit C, is provided with the difference between a reference r, representing a desired position of the mirror 300 relative to the second frame 340, and a measured position p of the mirror 300, the measured position p being obtained from the position measurement system 350. The position measurement system 350 can e.g. be an interferometer or encoder based measurement system. Based on the difference e between the desired position r and the actual position p, the controller C can control the actuator to exert a suitable force onto the mirror 300, in order to reduce the difference e. This can e.g. be done by the controller C outputting or generating a control signal Fc, said control signal being provided to the actuator 320 in order to generate the force 330. It can be pointed out that further control actions such as a feedforward control, not shown in Figure 3, may also be implemented to control the actuator 320.

In order to position optical components such as mirrors in a projection system of a lithographic apparatus, use is often made of electromagnetic actuators such as Lorentz actuators. Such actuators can e.g. comprise a first member, provided with a coil, which can e.g. be mounted to the first frame, and a second member, provided with a permanent magnet, which can e.g. be mounted to the optical component, e.g. the mirror. When the coil is supplied with a current, a force, e.g. force 330 indicated in Figure 3, is generated between the first member and the second member. In order to control the position of the mirror 300 in such manner, the controller C may rely on certain characteristics, such as the actuators internal stiffness or, more general, the actuator parasitic force. In addition or in parallel to the applied actuator force, a relative force between frame 310 and mirror 300 will in general be present which depends on the relative position between the frame 310 and the mirror 300. This force as function of relative position is defined as the internal stiffness. The internal stiffness may thus be considered to cause or create a linear or nonlinear force as function of position. This linear or non-linear force or force component may be referred to as a parasitic force of the actuator.

It has been observed that the occurrence of a non-zero internal stiffness of an actuator as applied in the positioning of an optical component, may adversely affect the positioning accuracy of the optical component. In this respect, it can also be pointed out that an actuator as applied may often be combined with or comprise a support, also referred to as gravity compensator, that is configured to at least partly compensate for the weight of the optical component. Such a support can e.g. be a passive support or an active support. A passive support can e.g. comprise a set of permanent magnets configured to generate a repelling force between the frame 310 and the mirror 300. Such supports may also suffer from having a limited accuracy resulting in a position dependent force or parasitic force, in addition to the contribution of the actuator.

The combination of an actuator and a passive support configured to at least partly compensate or counteract a weight of the optical component that is controlled may also be referred to as an actuator system.

Within the meaning of the present invention, actuator may either refer to a standalone actuator or an actuator including a passive support or gravity compensator.

As a result of the parasitic force of the actuator system, i.e. of the actuator and/or the support, a controller C may not always generate the most accurate control signals for the actuator to generate the required forces. In general, a controller or control unit will typically be reactive. For certain applications or use cases, this can have an adverse effect on the performance. In the present invention, a proactive approach is proposed.

It is an objective of the present invention to provide a method of determining a parasitic force of an actuator, whereby said determined parasitic force can subsequently be applied in an improved control method to control the actuator. It is a further objective of the present invention that the application of the determined parasitic force does not cause instability issues for the controller or control unit controlling the actuator.

In view of the above, the skilled person will understand that in order to accurately determine the parasitic force of the actuator, the relative position of the frame supporting the actuator and the mirror that is actuated needs to be known. For the arrangement as shown in Figure 3, it can be seen that the fact that the actuator is arranged on the first frame, whereas the mirror position is determined, or needs to be controlled, relative to the second frame complicates determining the relative position of the first frame 310 and the mirror 300.

It is known to apply a position sensor to measure a position of the first frame relative to the mirror. Said position sensor is indicated in Figure 3 with reference number 360. However, the noise level of said sensor 360 has been found to be unacceptably high. As such, directly using the output signal of said sensor 360 as an indication of the position of the mirror relative to the first frame and using the output signal to derive a parasitic force of the actuator has been found not to result in an improvement of the mirror positioning error.

In order to take account of the high noise level occurring in the position sensor 360 associated with the first frame 310, the following method has been devised to determine a parasitic force of the actuator 320.

It is proposed, in accordance with an embodiment of the present invention, to perform a low-pass filtering to the position signal of the position sensor 360 that measures the position of the optical component 300 relative to the first frame 310. Merely using this low-pass filtered position signal has however been found insufficient to predict or determine a parasitic force of the actuator 320; due to the low-pass filtering, rapid changes in the position of the optical component 300 relative to the second frame 340 are insufficiently taken into account. Therefore, in addition to the low-pass filtering of the position signal, the method of determining the parasitic force further makes use of a second position signal representing a position of the optical component relative to the second frame 340.

In an embodiment of the present invention, said second position signal can be obtained from the position measurement system 350 as applied to measure a position of the mirror, in general the optical component, relative to the second frame 340. In such embodiment, the second position signal may correspond to signal p shown in Figure 3.

In another embodiment of the present invention, the reference r representing the desired position of the optical component 300 relative to the second frame 340, can be used as the second position signal. Note that the reference r can also be referred to as a setpoint for the optical component relative to the second frame.

In accordance with the present invention, a high-pass filtering is applied to the second position signal representing a position of the optical component relative to the second frame, whereby said high-pass filtering is complementary to the low-pass filtering. By doing so, and combining the low-pass filtered first position signal and the high-pass filtered second position signal, a combined signal is obtained that can be used to accurately represent an actual position of the optical component 300 relative to the first frame.

Within the meaning of the present invention, a high-pass filter HP and a low-pass filter LP are considered to be complementary when the frequency characteristics of the complementary filters substantially fulfill the condition that HP + LP = 1. As an example, a second order low-pass filter HP(s) can be defined as:

$$LP(s) = \frac{\omega_{lp}^2}{s^2 + 2z_{lp}\omega_{lp}s + \omega_{lp}^2}$$

The complementary high-pass filter HP(s) would then become:

$$HP(s) = 1 - LP(s) = \frac{s^2 + 2z_{lp}\omega_{lp}s}{s^2 + 2z_{lp}\omega_{lp}s + \omega_{lp}^2}$$

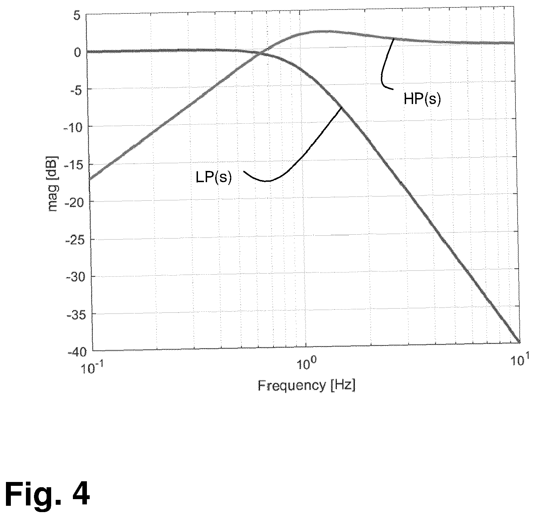

Figure 4 schematically shows Bode plots of these filters HP(s) and LP(s).

Based on the combined signal, a parasitic force of the actuator can be obtained. In particular, in an embodiment of the present invention, the parasitic force of the actuator at a given actual position of the optical component 300 relative to the first frame 310 can be obtained using a parasitic force characteristic of the actuator or a passive support of the actuator.

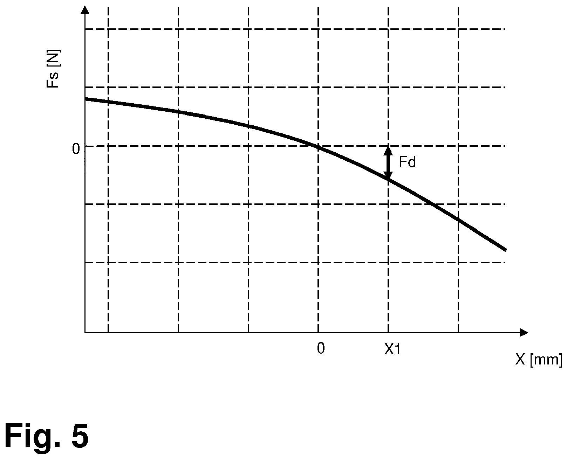

Figure 5 schematically shows such a parasitic force characteristic. Figure 5 schematically shows a variation of a force Fs as generated by a passive support, as a function of the position x of the optical component that is supported, relative to the frame onto which the passive support and the actuator are mounted. In the graph as shown, the nominal support force, generated in the nominal position x = 0 is set to zero. As can be seen from the graph, the passive support will generate a support force Fs that deviates from the nominal force, when the relative position between the optical component and the frame of the support and the actuator deviated from the nominal position. When the relative position corresponds to x = x1, the support will generate a support force that deviates by an amount Fd from the nominal support force. For a given relative position of the optical component and the frame onto which the passive support and actuator are mounted, said relative position being obtained from the combined low-pass filtered first position signal and the high-pass filtered second position signal, and a given parasitic force characteristic of the actuator or passive support of the actuator, a parasitic force of the actuator can be determined, e.g. as a force component deviating from a nominal force as generated by a passive support or an actuator.

As mentioned above, also an actuator as applied to control a position of an optical component may suffer from having a varying internal stiffness. i.e. such an actuator may also generate a parasitic force, e.g. expressed as Newtons/ Ampere in case of a Lorentz actuator, which is position dependent, i.e. depends on the relative position of the optical component and the frame supporting the actuator.

In an embodiment of the present invention, the method of obtaining or determining the parasitic force of the actuator as applied to position the optical component can e.g. be executed by a controller or control unit such as controller C shown in Figure 3.

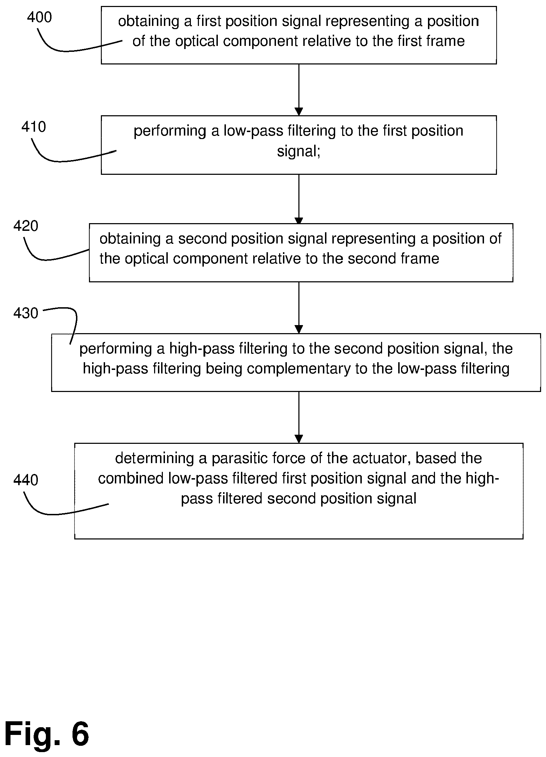

Figure 6 schematically illustrates an embodiment of the method of determining a parasitic force of an actuator according to the present invention. In the embodiment as shown, the method is applied in case a position control or positioning of an optical component is desirable relative to a frame, whereby an actuator that is configured to perform the positioning of the optical component is mounted to a different frame. In the embodiment of Figure 6, the actuator is thus considered mounted to a first frame, whereas the optical component is to be positioned relative to a second frame.

In accordance with an embodiment of the invention, the method of determining a parasitic force of an actuator comprises:

- a first step 400 of obtaining a first position signal representing a position of the optical component relative to the first frame.
- a second step 410 of performing a low-pass filtering to the first position signal.
- a third step 420 of obtaining a second position signal representing a position of the optical component relative to the second frame.
- a fourth step 430 of performing a high-pass filtering to the second position signal, the high-pass filtering being complementary to the low-pass filtering.
- and a fifth step 440 of determining the parasitic force of the actuator, based on the combined low-pass filtered first position signal and the high-pass filtered second position signal.

With respect to the numbering of the steps 400 - 440, it can be pointed out that this numbering does not imply a strict chronological order in which the steps need to be performed. As an example, it can be pointed out that steps 400 and 410 may be performed in parallel to steps 420 and 430.

In an embodiment, the fifth step 440 as shown can e.g. comprise:

- determining a relative position of the optical component and the first frame, based on the combined low-pass filtered first position signal and the high-pass filtered second position signal, and
- determining the parasitic force of the actuator based on the relative position and a parasitic force characteristic of the actuator.

According to an aspect of the present invention, there is further provided a method of controlling an actuator, the method making use of the parasitic force as obtained using the method of obtaining a parasitic force of an actuator according to the present invention.

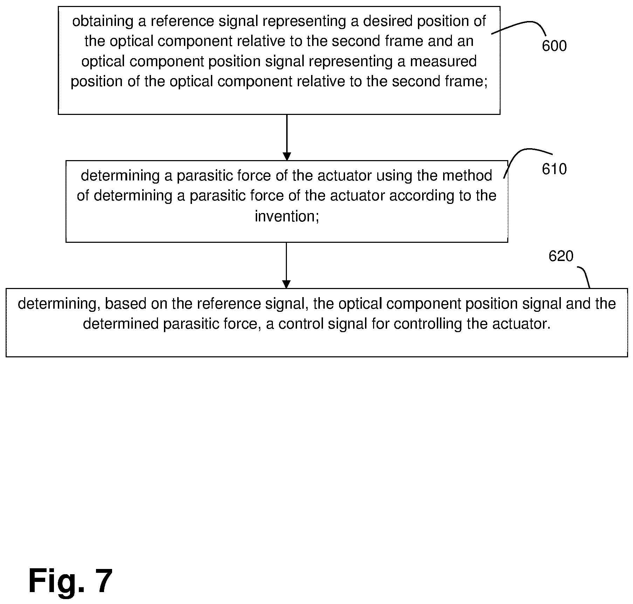

Figure 7 schematically illustrates such an actuator control method according an embodiment of the present invention.

In accordance with the embodiment of the invention, the control method is intended for an actuator that is mounted to a first frame and that is configured to control a position of an optical component relative to a second frame. The method comprises:

- a first step 600 of obtaining a reference signal representing a desired position of the optical component relative to the second frame and an optical component position signal representing a measured position of the optical component relative to the second frame;
- a second step 610 of determining a parasitic force of the actuator using the method of determining a parasitic force of the actuator according to the invention;
- a third step 620 of determining, based on the reference signal, the optical component position signal and the determined parasitic force, a control signal for controlling the actuator.

In an embodiment, the control method as illustrated in Figure 6 can be implemented in a control scheme of the actuator, e.g. a control scheme as illustrated in Figure 2. This can be done in various ways, as will be illustrated below.

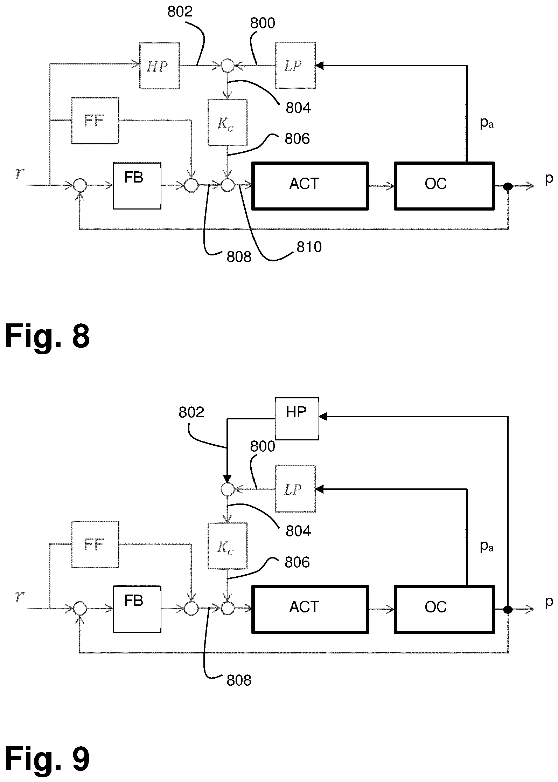

Figure 8 schematically illustrates a first embodiment of a control scheme for an actuator in which the control method according to the present invention is implemented.

In Figure 8, signal r represent a position reference for the optical component OC that needs to be positioned. The signal r may thus be considered a desired position of the optical component OC relative to a reference frame or sensor frame as discussed above. The reference or sensor frame is also referred as the second frame. The signal r may also be referred to as a reference signal, position reference signal or set point or set point signal.

In Figure 8, signal p represents a measured position of the optical component OC relative to the reference frame or sensor frame. Signals r and p thus correspond to signals r and p as shown in Figure 3. With reference to Figure 3, p may thus be a position of the optical component 300 as measured by the position measurement system 350. r and p may e.g. represent desired and actual positions in one or more degrees of freedom.

In Figure 8, $p_a$ represents a measured position of the optical component relative to a frame onto which the actuator is mounted. Above, this frame is e.g. referred to as the force frame or the first frame. With reference to Figure 3, $p_a$ may thus be a position of the optical component as measured by the position measurement system 360.

As can be seen in Figure 8, the position signal $p_a$, i.e. representing a measured position of the optical component relative to the force frame, is subjected to a low-pass filtering, indicated by low-pass filter LP. In a similar manner, the reference signal r is subjected to a high-pass filtering, indicated by the high-pass filter HP. The filtered signals 800 and 802 are subsequently combined, e.g. added. Said combined signal 804 has been found to accurately represent an actual relative position between the optical component and the force frame or first frame. It can be pointed out that without the high-pass filtered contribution, obtained from the reference signal r, dynamic effects such as displacements of the optical component are insufficiently accounted for. Phrased differently, displacements of the optical component taking place at a comparatively high speed, causing corresponding displacements of the optical component relative to the force frame, could, due to a variable stiffness or parasitic force of the actuator or passive support of the actuator, result in an inaccurate control of the actuator.

Based on the combined signal 804, a parasitic force can be determined, e.g. using a parasitic force characteristic of the actuator or passive support of the actuator. This parasitic force calculation is indicated by Kc in Figure 8. The parasitic force 806 as determined, e.g. a force correction as shown in Figure 5, can then be combined with a control signal 808 as generated using feedforward control FF and feedback control FB, thereby arriving at a corrected control signal 810 which can be applied to control the actuator ACT that controls a position of the optical component OC. As can be seen in Figure 8, the feedback control FB acts on the difference between the reference signal r and the position signal p, whereas the feedforward control FF is based on the reference signal r, in a similar manner as indicated with reference to Figure 2.

As an alternative to applying a high-pass filtering to the reference signal r, to obtain a high-pass filtered signal such as signal 802, the high-pass filtering may also be applied to the signal p, representing the measured position of the optical component OC relative to the reference frame. Such embodiment is schematically shown in Figure 9.

Compared to Figure 8, the high-pass filtering HP is now applied to the measured position signal p, rather than being applied to the reference r. It has been observed that by doing so, the obtained combined signal 804, which now combines a low-pass filtered signal of the position signal $p_a$ and a high-pass filtered signal of the position signal p, also provides an accurate representation of the actual relative position between the optical component OC and the force frame or first frame. It may thus be used, in a similar manner as shown in Figure 8, to determine the required parasitic force 806.

In an embodiment of the present invention, the control signals generated by the controller or the measurement signals, e.g. signals p and $p_a$, may need to undergo one or more transformations, e.g. to take account of different coordinate systems, e.g. applied in the controller, the measurement systems associated with the optical component OC or the actuator ACT.

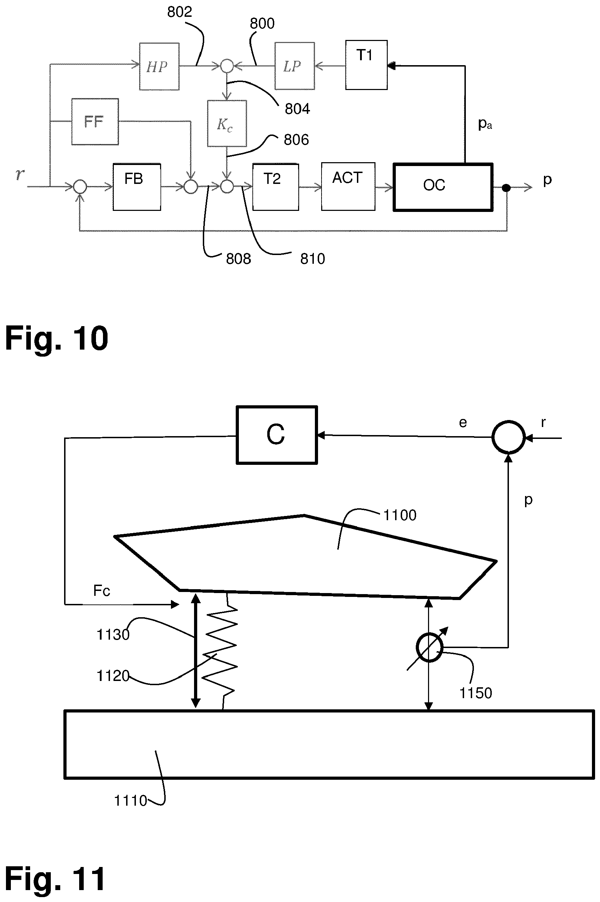

Figure 10 schematically shows a control scheme according to an embodiment illustrating two of such transformations, T1, T2.

The control scheme as schematically shown in Figure 10 substantially corresponds to the scheme of Figure 8, apart from the following:

In Figure 10, the position signal $p_a$ is subjected to a transformation T1 in order to take account the different coordinate systems applied by the measurement system generating the signal $p_a$ and the controller generating the actuator control signal.

Similarly, the control signal 810 as generated by the controller is transformed, using transformation T2 to take account of the actuator coordinate system.

With respect to said transformations, e.g. T1 or T2, it can be pointed out that these transformations do not affect the frequency content of the signals that are transformed. As such, the filtering operations applied, e.g. the low-pass filtering LP, could also be applied prior to the transformation T1. Or, the parasitic force 806 could also, after a suitable transformation, be combined with the signal 808 after the transformation T2, rather than before the transformation T2.

In an embodiment, the present invention also provides a method of determining a parasitic force of an actuator configured to control a position of an optical component, whereby the position of the optical component is controlled relative to the same frame as the frame supporting the actuator. Such an arrangement is schematically shown in Figure 11.

Figure 11 schematically shows a mirror 110, in general an optical component, as can e.g. be applied in a projection system of a lithographic apparatus such as apparatus LA shown in Figure 1. Figure 11 schematically shows a frame 1110 that is configured to support or hold an actuator 1120 that is configured to exert a force, indicated by the arrow 1130, onto the mirror 1100. Figure 11 further shows a position measurement system 1150 configured to measure a position of the mirror 1100 relative to the frame 1110. Figure 11 further schematically shows how a position control of the mirror 300 can be realized, which is similar to the arrangement in Figure 3. A controller or control unit C, is provided with the difference between a reference r, representing a desired position of the mirror 1100 relative to the frame 1110, and a measured position p of the mirror 1100, the measured position p being obtained from the position measurement system 1150. The position measurement system 1150 can e.g. be an interferometer or encoder based measurement system. Based on the difference e between the desired position r and the actual position p, the controller C can control the actuator to exert a suitable force onto the mirror 300, in order to reduce the difference e. This can e.g. be done by the controller C outputting or generating a control signal Fc, said control signal being provided to the actuator 320 in order to generate the force 330. It can be pointed out that further control actions such as a feedforward control, not shown in Figure 3, may also be implemented to control the actuator 320. Similar to the arrangement having the first and second frame, the arrangement shown in Figure 11 may also suffer from the occurrence of a parasitic force of the actuator 1120, i.e. a force depending on the relative position of the frame 1110 and the mirror 1100. In order to determine such force, knowledge about the relative position of the frame 1110 supporting the actuator 1120 and the actuated optical component 1100 is important. It has been observed by the inventors that the application of a position measurement signal as obtained from the position measurement system 1150 to determine the parasitic force may cause an instability in the feedback loop of the controller or control unit C. Therefore, in an embodiment of the present invention, the following method of determining a parasitic force of an actuator is proposed. This method may e.g. be applied in case the position of the optical component is controlled by the actuator relative to the same frame as the frame supporting the actuator.

This method of determining a parasitic force of an actuator of an optical component, the actuator being mounted to a frame and configured to control a position of the optical component relative to the frame, comprises the following steps:

- obtaining a position signal representing a position of the optical component relative to the frame. With reference to Figure 11, this can e.g. be position signal p as obtained from the position measurement system 1150.
- performing a low-pass filtering to the position signal, e.g. position signal p.
- obtaining a reference signal representing a desired position of the optical component relative to the frame. With reference to Figure 11, this can e.g. be the reference signal r representing a desired position of the optical component 1100.
- performing a high-pass filtering to the reference signal r, the high-pass filtering being complementary to the low-pass filtering;
- determining a parasitic force of the actuator, based on the combined low-pass filtered position signal and the high-pass filtered reference signal.

In this embodiment of the present invention, the position signal p of the position measurement system 1150 is not used directly to derive or determine the parasitic force. Rather, the position signal p is low-pass filtered and the low-pass filtered position signal is combined with a high-pass filtered reference signal. It has been observed that by doing so, the risk of instability in the feedback loop of the controller or control unit C can be mitigated.

In a similar manner as discussed above, said method of determining a parasitic force of an actuator can be implemented in a control method for an actuator controlling a position of an optical component.

The control method according to the present invention may e.g. be implemented in a controller or control unit for an actuator. Such a control unit may e.g. comprise a processing unit or processor and a memory unit for storing data such as measurement signals. Such controller or control unit may e.g. have an input terminal to receive input signals such as measurement signals or reference signals or setpoints. The controller may also have an output terminal to output one or more control signals, e.g. to control an actuator, the control signals being obtained by processing the input signals.

As such, according to an aspect of the present invention, there is provided a control unit that is configured to perform the control method according to the present invention. Such a control unit may e.g. be applied in an optical system according to the invention. Such an optical system can e.g. comprise:

- an optical component such as a mirror;
- an actuator mounted to a first frame or frame of the system, the actuator being configured to control a position of the optical component relative to a second frame of the system or relative to the frame of the system, and
- a control unit, the control unit being configured to perform the method of controlling an actuator according to the invention.

A combination of such optical systems according to the invention may e.g. be applied in a projection system for a lithographic apparatus, e.g. an EUV lithographic apparatus as described above.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the clauses set out below.

Clause 13 An optical system comprising:

an optical component such as a mirror;
an actuator mounted to a first frame of the apparatus, the actuator being configured to control a position of the optical component relative to a second frame of the apparatus;
a control unit, the control unit being configured to:
obtaining a reference signal representing a desired position of the optical component relative to the second frame and an optical component position signal representing a measured position of the optical component relative to the second frame;

determining a parasitic force of the actuator by:

obtaining a first position signal representing a position of the optical component relative to the first frame;
performing a low-pass filtering to the first position signal to obtain a low-pass filtered signal;
performing a high-pass filtering to the optical component position signal or the reference signal to obtain a high-pass filtered signal, the high-pass filtering being complementary to the low-pass filtering;
determining a parasitic force of the actuator, based on the combined low-pass filtered signal and the high-pass filtered signal;
determining, based on the reference signal, the optical component position signal and the determined parasitic force, a control signal for controlling the actuator.

Clause 14 The optical system according to clause 13, wherein determining the parasitic force comprises:

determining a relative position of the optical component and the first frame, based on the combined low-pass filtered signal and the high-pass filtered signal.
determining the parasitic force based on the relative position and a parasitic force characteristic of the actuator.

Clause 15 The optical system according to any of the clauses 13 to 14, wherein the optical component comprises an EUV mirror.

Clause 16 The optical system according to any of the clauses 13 to 15, further comprising a position measurement system configured to generate the optical component position signal.

Clause 17 The optical system according to clause 16, wherein the position measurement system comprises an interferometer based or encoder based measurement system.

Clause 18 Projection system for use in a lithographic apparatus, the projection system comprising an optical system according to any of the clauses 13 to 17.

Clause 19 A lithographic apparatus comprising a projection system according to clause 18.

**Claims**

1. A method of determining a parasitic force of an actuator of an optical component, the actuator being mounted to a first frame and being configured to control a position of the optical component relative to a second frame, the method comprising:

    - obtaining a first position signal representing a position of the optical component relative to the first frame;
    - performing a low-pass filtering to the first position signal;
    - obtaining a second position signal representing a position of the optical component relative to the second frame;
    - performing a high-pass filtering to the second position signal, the high-pass filtering being complementary to the low-pass filtering;
    - determining the parasitic force of the actuator, based on the combined low-pass filtered first position signal and the high-pass filtered second position signal.

2. The method according to claim 1, wherein determining the parasitic force of the actuator comprises:

    - determining a relative position of the optical component and the first frame, based on the combined low-pass filtered first position signal and the high-pass filtered second position signal.
    - determining the parasitic force of the actuator based on the relative position and a parasitic force characteristic of the actuator.

3. The method according to claim 1 or 2, wherein the second position signal correspond to a reference signal representing a desired position of the optical component.

4. A method of controlling an actuator, the actuator being mounted to a first frame and being configured to control a position of an optical component relative to a second frame, the method comprising:

 - obtaining a reference signal representing a desired position of the optical component relative to the second frame and an optical component position signal representing a measured position of the optical component relative to the second frame;
 - determining a parasitic force of the actuator using the method according to any of the claims 1 to 3,
 - determining, based on the reference signal, the optical component position signal and the determined parasitic force, a control signal for controlling the actuator.

5. The method according to claim 4, wherein the second position signal corresponds to the reference signal.

6. The method according to claim 4, wherein the second position signal corresponds to the optical component position signal.

7. The method according to claim 4, further comprising:

 - performing a low-pass filtering to the optical component position signal.

8. A method of determining a parasitic force of an actuator of an optical component, the actuator being mounted to a frame and configured to control a position of the optical component relative to the frame, the method comprising:

 - obtaining a position signal representing a position of the optical component relative to the frame;
 - performing a low-pass filtering to the position signal;
 - obtaining a reference signal representing a desired position of the optical component relative to the frame;
 - performing a high-pass filtering to the reference signal, the high-pass filtering being complementary to the low-pass filtering;
 - determining the parasitic force of the actuator, based on the combined low-pass filtered position signal and the high-pass filtered reference signal.

9. The method according to claim 8, wherein determining the parasitic force of the actuator comprises:

 - determining a relative position of the optical component and the frame, based on the combined low-pass filtered position signal and the high-pass filtered reference signal.
 - determining the parasitic force of the actuator based on the relative position and a parasitic force characteristic of the actuator.

10. A method of controlling an actuator, the actuator being mounted to a frame and being configured to control a position of an optical component relative to the frame, the method comprising:

 - obtaining a reference signal representing a desired position of the optical component relative to the frame and an optical component position signal representing a measured position of the optical component relative to the frame;
 - determining a parasitic force of the actuator using the method according to claim 8 or 9;
 - determining, based on the reference signal, the optical component position signal and the determined parasitic force, a control signal for controlling the actuator.

11. An optical system comprising:

 - an optical component such as a mirror;
 - an actuator mounted to a first frame of the optical system, the actuator being configured to control a position of the optical component relative to a second frame of the optical system;
 - a control unit, the control unit being configured to perform the method according to any of the claims 4 to 7.

12. An optical system comprising:

 - an optical component such as a mirror;
 - an actuator mounted to a frame of the optical system, the actuator being configured to control a position of the optical component relative to the frame of the optical system;
 - a control unit, the control unit being configured to perform the method according to claim 10.

13. An optical system comprising:

 - an optical component such as a mirror;
 - an actuator mounted to a first frame of the apparatus, the actuator being configured to control a position of the optical component relative to a second frame of the apparatus;
- a control unit, the control unit being configured to:

  ◦ obtaining a reference signal representing a desired position of the optical component relative to the second frame and an optical component position signal representing a measured position of the optical component relative to the second frame;
  ◦ determining a parasitic force of the actuator by:

    ▪ obtaining a first position signal representing a position of the optical component relative to the first frame;
    ▪ performing a low-pass filtering to the first position signal to obtain a low-pass filtered signal;
    ▪ performing a high-pass filtering to the optical component position signal or the reference signal to obtain a high-pass filtered signal, the high-pass filtering being complementary to the low-pass filtering;
    ▪ determining a parasitic force of the actuator, based on the combined low-pass filtered signal and the high-pass filtered signal;

  ◦ determining, based on the reference signal, the optical component position signal and the determined parasitic force, a control signal for controlling the actuator.

14. Projection system for use in a lithographic apparatus, the projection system comprising an optical system according to any of the claims 11 to 13.

15. A lithographic apparatus comprising a projection system according to claim 14.

**FIG. 1**

**Fig. 2**

**Fig. 3**

## Fig. 4

Fig. 5

400 obtaining a first position signal representing a position of the optical component relative to the first frame

410 performing a low-pass filtering to the first position signal;

420 obtaining a second position signal representing a position of the optical component relative to the second frame

430 performing a high-pass filtering to the second position signal, the high-pass filtering being complementary to the low-pass filtering

440 determining a parasitic force of the actuator, based the combined low-pass filtered first position signal and the high-pass filtered second position signal

# Fig. 6

obtaining a reference signal representing a desired position of the optical component relative to the second frame and an optical component position signal representing a measured position of the optical component relative to the second frame;

600

determining a parasitic force of the actuator using the method of determining a parasitic force of the actuator according to the invention;

610

620

determining, based on the reference signal, the optical component position signal and the determined parasitic force, a control signal for controlling the actuator.

# Fig. 7

# Fig. 8

# Fig. 9

Fig. 10

Fig. 11

Europäisches Patentamt

European Patent Office

Office européen des brevets

# EUROPEAN SEARCH REPORT

Application Number

EP 22 18 3960

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/129317 A1 (RONDE MICHAEL [NL] ET AL) 2 May 2019 (2019-05-02) * paragraphs [0055] – [0075]; figures 3,4 * * paragraphs [0086] – [0111]; figure 7 * | 1-15 | INV. G03F7/20 |
| A | US 2017/038693 A1 (DE JONGH ROBERTUS JOHANNES MARINUS [NL] ET AL) 9 February 2017 (2017-02-09) * paragraphs [0051] – [0091]; figures 3-5 * | 1-15 | |
| A | US 2009/067298 A1 (KIM SOO YONG [KR] ET AL) 12 March 2009 (2009-03-12) * paragraphs [0035] – [0040]; figures 3,5 * | 1-15 | |
| A | JP H10 241171 A (NEC CORP) 11 September 1998 (1998-09-11) * paragraphs [0009] – [0010]; figure 4 * | 1-15 | |

TECHNICAL FIELDS
SEARCHED      (IPC)

G03F
G11B

The present search report has been drawn up for all claims

| Place of search | Date of completion of the search | Examiner |
|---|---|---|
| Munich | 19 December 2022 | van Toledo, Wiebo |

EPO FORM 1503 03.82 (P04C01)

## ANNEX TO THE EUROPEAN SEARCH REPORT
## ON EUROPEAN PATENT APPLICATION NO.

**EP 22 18 3960**

This annex lists the patent family members relating to the patent documents cited in the above-mentioned European search report.
The members are as contained in the European Patent Office EDP file on
The European Patent Office is in no way liable for these particulars which are merely given for the purpose of information.

**19-12-2022**

| Patent document cited in search report | | Publication date | Patent family member(s) | | Publication date |
|---|---|---|---|---|---|
| US 2019129317 | A1 | 02-05-2019 | NONE | | |
| US 2017038693 | A1 | 09-02-2017 | CN | 106170727 A | 30-11-2016 |
| | | | JP | 6618921 B2 | 11-12-2019 |
| | | | JP | 2017517021 A | 22-06-2017 |
| | | | KR | 20160144491 A | 16-12-2016 |
| | | | NL | 2014487 A | 02-11-2015 |
| | | | TW | 201543185 A | 16-11-2015 |
| | | | US | 2017038693 A1 | 09-02-2017 |
| | | | WO | 2015158487 A1 | 22-10-2015 |
| US 2009067298 | A1 | 12-03-2009 | CN | 101382772 A | 11-03-2009 |
| | | | KR | 20090025983 A | 11-03-2009 |
| | | | TW | 200928628 A | 01-07-2009 |
| | | | US | 2009067298 A1 | 12-03-2009 |
| JP H10241171 | A | 11-09-1998 | NONE | | |

EPO FORM P0459

For more details about this annex : see Official Journal of the European Patent Office, No. 12/82